# EUROPEAN PATENT SPECIFICATION

(11) **EP 3 010 046 B1**
(45) Date of publication and mention of the grant of the patent: **21.04.2021**
(21) Application number: 15189610.7
(22) Date of filing: 13.10.2015
(51) Int. Cl.: H01L 31/0687, H01L 31/0693, H01L 31/0304, H01L 31/18, H01L 31/043

(54) **COMPOUND-SEMICONDUCTOR PHOTOVOLTAIC CELL AND MANUFACTURING METHOD OF COMPOUND-SEMICONDUCTOR PHOTOVOLTAIC CELL**
PHOTOVOLTAISCHE VERBINDUNGSHALBLEITERZELLE UND HERSTELLUNGSVERFAHREN EINER PHOTOVOLTAISCHEN VERBINDUNGSHALBLEITERZELLE
CELLULE PHOTOVOLTAÏQUE À SEMI-CONDUCTEUR COMPOSÉ ET PROCÉDÉ DE FABRICATION ASSOCIÉ

(30) Priority: 15.10.2014 JP 2014211230
(43) Date of publication of application: 20.04.2016
(73) Proprietor: Ricoh Company, Ltd., Tokyo 143-8555 (JP)
(72) Inventor: SATO, Shunichi, Ohta-ku, Tokyo 143-8555 (JP)
(74) Representative: J A Kemp LLP

(56) References cited:
- WO-A1-2014/142340
- US-A1- 2011 124 146
- US-A1- 2014 252 312
- CHMIELEWSKI DANIEL J ET AL: "Metamorphic GaAsP Tunnel Junctions for High-Efficiency III-V/IV Multijunction Solar Cell Technology", IEEE JOURNAL OF PHOTOVOLTAICS, I E E E, US, vol. 4, no. 5, 18 August 2014 (2014-08-18) , pages 1301-1305, XP011556830, ISSN: 2156-3381, DOI: 10.1109/JPHOTOV.2014.2328592 [retrieved on 2014-08-18]

## Description

### BACKGROUND OF THE INVENTION

### 1. Field of the Invention

The disclosures herein generally relate to a compound-semiconductor photovoltaic cell and a manufacturing method of the compound-semiconductor photovoltaic cell.

### 2. Description of the Related Art

Since band gap energy or a lattice constant of a compound-semiconductor varies depending on material composition, multi-junction type photovoltaic cells in which energy conversion efficiency is enhanced by sharing a wavelength range of solar light have been manufactured.

At present, triple-junction photovoltaic cells including a Ge cell/Ga(In)As cell/GaInP cell using a lattice matching material on a Ge substrate, which has almost the same lattice constant as gallium arsenide (GaAs), having band gaps for respective cells of 1.88 eV/1.40 eV/0.67 eV, are generally used.

A compound-semiconductor photovoltaic cell has an efficiency which is about twice an efficiency of a silicon (Si)-based photovoltaic cell. However, by reason of cost of a substrate, small size of the substrate or the like, the compound-semiconductor photovoltaic cell is several orders of magnitude more expensive than the Si-based photovoltaic cell. Therefore, the compound-semiconductor photovoltaic cells have been used for a special purpose, such as an artificial satellite in space, for example.

Recently, a compound-semiconductor photovoltaic cell has been put to practical use for a terrestrial application (for general purpose on earth), by combining an inexpensive plastic lens and a small-sized photovoltaic cell, forming a concentration type cell, reducing an amount of compound-semiconductor which is more expensive than a normal planar cell, and realizing cost reduction.

However, power generation costs of photovoltaic cells including Si are still high, further cost reduction is important, and enhancement of energy conversion efficiency and reduction of manufacturing post are being studied.

As described above, a band-gap balance of the currently prevailing lattice-matching type triple-junction photovoltaic cell using a Ge substrate is not optimum from a viewpoint of an electric current band gap. A configuration, in which a band gap of a bottom cell in increased, has promise.

Proceedings of the 29st IEEE Photovoltaic Specialists Conference (2010) pp. 412-417 discloses, as an example of high efficiency, a triple-junction photovoltaic cell in which band gaps of the respective cells are set to 1.9 eV/1.42 eV/1.0 eV, aiming at optimization of the band gap balance.

For the cell of 1.9 eV and the cell of 1.42 eV, GaInP and GaAs which lattice match with a GaAs substrate are used, respectively. On the other hand, for the cell of 1.0 eV, a GaInAs cell, which does not lattice match with the GaAs substrate and causes lattice mismatch of about 2% to occur, is used. In order to realize the above configuration, a crystal grows in an opposite direction to those of normal photovoltaic cells.

Specifically, on the GaAs substrate, it grows in an order of a GaInP cell and a GaAs cell. Next, it causes the GaInAs cell to grow via a lattice relaxation buffer layer for changing lattice constant difference. Then, a surface is adhered to a support substrate, and finally by removing the GaAs substrate a triple-junction photovoltaic cell is manufactured. Light incidence is on a side of the GaInP cell in which band gap is great.

Moreover, Japanese Published Patent Application No. 2002-289884, for example, discloses a mechanical stack type photovoltaic cell overlaying a GaAs substrate on which a GaAs top cell is formed and an InP substrate on which a GaInAsP bottom cell is formed. The respective cells are not physically connected directly in a light reception region. The cells are joined mechanically, and linked optically via an air gap.

Moreover, Applied Physics Letters, 101, 191111 (2012) discloses a photovoltaic cell made by a series junction method using an electrically-conductive nanoparticle array. A GaAs substrate has a photovoltaic cell and an InP substrate which are connected via a Pd nanoparticle array using a VDW (Van-der-Waals) method. Electric current flows via ohmic contact of nanoparticles and semiconductor.

Moreover, publication of US Patent Application No. 2012/0138116 discloses a photovoltaic cell formed by directly joining a surface of a GaAs substrate on which a GaInP top cell is formed and a surface of an InP substrate on which a GaInAs bottom cell is formed. On the GaAs substrate, a cell of a short wavelength region can be formed easily using a lattice matching material, and on the InP substrate, a long wavelength region can be formed easily using a lattice matching material.

WO 2014/142340 A1 (RICOH CO LTD [JP]; SATO SHUNICHI [JP]) 18 September 2014 (2014-09-18), discloses background information.

CHMIELEWSKI DANIEL J ET AL: "Metamorphic GaAsP Tunnel Junctions for High-Efficiency III-V/IV Multijunction Solar Cell Technology", IEEE JOURNAL OF PHOTOVOLTAICS, I E E E, US, vol. 4, no. 5, 18 August 2014 (2014-08-18), pages 1301-1305, XP011556830, ISSN: 2156-3381, DOI: 10.1109/JPHOTOV.2014.2328592 [retrieved on 2014-08-18], discloses background information.

US 2014/252312 A1 (LUMB MATTHEW [US] ET AL) 11 September 2014 (2014-09-11), discloses background information.

US 2011/124146 A1 (PITERA ARTHUR J [US] ET AL) 26 May 2011 (2011-05-26), discloses background information.

### SUMMARY OF THE INVENTION

It is a general object of at least one embodiment of the present invention to provide a compound-semiconductor photovoltaic cell as defined in claim 1 and a manufacturing method of the compound-semiconductor photovoltaic cell as defined in claim 10 that substantially obviate one or more problems caused by the limitations and disadvantages of the related art.

Aspects of the invention are set out in the appended claims.

In one embodiment, a compound-semiconductor photovoltaic cell includes a compound-semiconductor substrate; one or more first photoelectric conversion cells formed of a first compound-semiconductor material and laminated on the compound-semiconductor substrate; a first junction layer formed of a second compound-semiconductor material and laminated on the one or more first photoelectric conversion cells; a second junction layer formed of a third compound-semiconductor material and joined to the first junction layer directly or indirectly; and one or more second photoelectric conversion cells formed of a fourth compound-semiconductor material, joined to the one or more first photoelectric conversion cells via the first junction layer and the second junction layer, and arranged on a light incident side of the one or more first photoelectric conversion cells in a light incident direction. Band gaps of the one or more first photoelectric conversion cells and the one or more second photoelectric conversion cells are made smaller from the incident side toward a deep side in the light incident direction. In a case of a single second photoelectric conversion cell, a band gap of the second junction layer is greater than a band gap of the second photoelectric conversion cell, and in a case of plural second photoelectric conversion cells, the band gap of the second junction layer is greater than a band gap of at least one second conversion cell of the plural second photoelectric conversion cells. The one or more second photoelectric conversion cells are gallium arsenide (GaAs)-based photovoltaic cells, and the second junction layer is a gallium phosphide arsenide (GaPAs) layer.

In another embodiment, a manufacturing method of a compound-semiconductor photovoltaic cell includes forming one or more first photoelectric conversion cells of a first compound-semiconductor material on a first compound-semiconductor substrate; forming a first junction layer of a second compound-semiconductor material on the one or more first photoelectric conversion cells; forming one or more second photoelectric conversion cells of a fourth compound-semiconductor material which are arranged on a light incident side of the one or more first photoelectric conversion cells in a light incident direction on a second compound-semiconductor substrate; forming a second junction layer of a third compound-semiconductor material on the one or more second photoelectric conversion cells; joining the first junction layer to the second junction layer directly or indirectly; and removing the second compound-semiconductor substrate. Band gaps of the one or more first photoelectric conversion cells and the one or more second photoelectric conversion cells are made smaller from the incident side toward a deep side in the light incident direction. In a case of a single second photoelectric conversion cell, a band gap of the second junction layer is greater than a band gap of the second photoelectric conversion cell, and in a case of plural second photoelectric conversion cells, the band gap of the second junction layer is greater than a band gap of at least one second conversion cell of the plural second photoelectric conversion cells. The one or more second photoelectric conversion cells are GaAs-based photovoltaic cells, and the second junction layer is a GaPAs layer.

According to the embodiment of the present application, a compound-semiconductor photovoltaic cell achieving high efficiency, and a manufacturing method of the compound-semiconductor photovoltaic cell can be provided.

### BRIEF DESCRIPTION OF THE DRAWINGS

Other objects and further features of embodiments will become apparent from the following detailed description when read in conjunction with the accompanying drawings, in which:
Fig. 1 is a cross-sectional diagram illustrating an example of a compound-semiconductor photovoltaic cell 100 according to a first embodiment;
Figs. 2A and 2B are diagrams illustrating an example of a manufacturing method of the compound-semiconductor photovoltaic cell 100 according to the first embodiment;
Figs. 3A and 3B are diagrams illustrating another example of the manufacturing method of the compound semiconductor photovoltaic cell 100 according to the first embodiment;
Fig. 4 is a cross-sectional diagram illustrating an example of a compound-semiconductor photovoltaic cell 200 according to a second embodiment;
Fig. 5 is a cross-sectional diagram illustrating an example of a compound-semiconductor photovoltaic cell 201 according to a variation of the second embodiment;
Fig. 6 is a cross-sectional diagram illustrating an example of a compound-semiconductor photovoltaic cell 300 according to a third embodiment; and
Fig. 7 is a cross-sectional diagram illustrating an example of a compound-semiconductor photovoltaic cell 400 according to a fourth embodiment.

### DESCRIPTION OF THE PREFERRED EMBODIMENTS

In the following, embodiments to which an compound-semiconductor photovoltaic cell and a manufacturing method of the compound-semiconductor photovoltaic cell according to the present invention are applied will be described with reference to the accompanying drawings.

### <First embodiment>

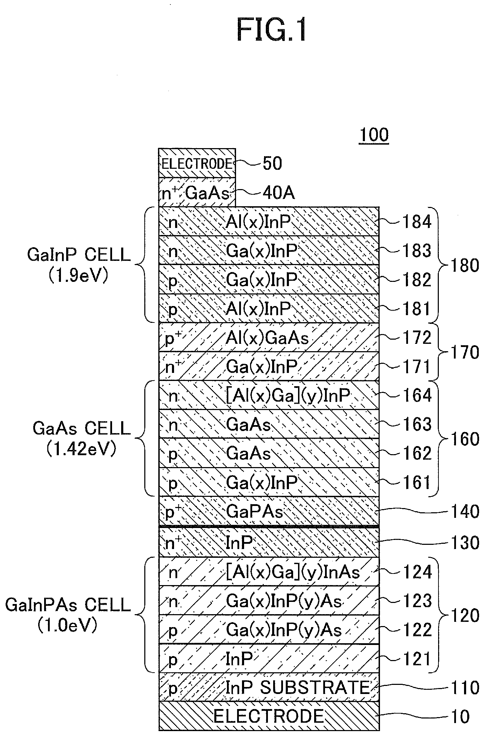

Fig. 1 is a cross-sectional diagram illustrating a compound-semiconductor photovoltaic cell 100 according to a first embodiment.

The compound-semiconductor photovoltaic cell 100 includes an electrode 10, an InP substrate 110, a GaInPAs cell 120, a junction layer 130, a junction layer 140, a GaAs cell 160, a tunnel junction layer 170, a GaInP cell 180, a contact layer 40A and an electrode 50.

The compound-semiconductor photovoltaic cell 100 according to the first embodiment is a triple-junction type photovoltaic cell in which the GaInPAs cell 120 (1.0 eV), the GaAs cell 160 (1.42 eV), and the GaInP cell 180 (1.9 eV) are directly connected.

Here, a cell included in the compound-semiconductor photovoltaic cell 100 includes an InP (indium phosphide)-based photoelectric conversion cell and a GaAs (gallium arsenide)-based photoelectric conversion cell. The InP-based photoelectric conversion cell is a photoelectric conversion cell almost lattice matching with InP and formed of a material system, a crystal of which can be grown on the InP substrate 110. Here, a material which almost lattice matches with InP, and a crystal of which can be grown on the InP substrate 110 will be called an "InP lattice matching-based material", and a cell formed of the InP lattice matching-based material will be called an "InP lattice matching-based material cell".

Moreover, the GaAs-based photoelectric conversion cell is a photoelectric conversion cell almost lattice matching with GaAs or Ge, a lattice constant of which is close to GaAs, and formed of a material system, a crystal of which can be grown on the GaAs substrate or a Ge substrate. Here, a material which almost lattice matches with GaAs or Ge, a lattice constant of which is close to GaAs, and a crystal of which can be grown on the GaAs substrate or on the Ge substrate will be called a "GaAs lattice matching-based material", and a cell formed of the GaAs lattice matching-based material will be called a "GaAs lattice matching-based material cell".

Meanwhile, the above-described configurations are the same also in second to fourth embodiments.

In the compound-semiconductor photovoltaic cell 100, the GaInPAs cell 120 is an InP-based photoelectric conversion cell, and the GaAs cell 160 and the GaInP cell 180 are GaAs-based photoelectric conversion cells.

Here, the InP substrate 110 is an example of a compound-semiconductor substrate or a first compound-semiconductor substrate. The GaInPAs cell 120 is an example of a first photoelectric conversion cell manufactured of a first compound-semiconductor material.

Moreover, the junction layer 130 is an example of a first junction layer manufactured of a second compound-semiconductor material and laminated on the GaInPAs cell 120. The junction layer 140 is an example of a second junction layer manufactured of a third compound-semiconductor material. The junction layers 130 and 140 function also as tunnel junction layers. The GaAs cell 160 and the GaInP cell 180 are examples of plural second photoelectric conversion cells manufactured of a fourth compound-semiconductor material.

In Fig. 1, an incident direction of light is a direction from an upper part to a lower part in the drawing (direction from the GaInP cell 180 to the GaInPAs cell 120).

The electrode 10 is a lower electrode positioned on a deep side in the light incident direction. For the electrode 10, for example, an electrode in which metal layers of Ti/Pt/Au or the like may be used.

For the InP substrate 110, for example, a wafer of a single crystal of p-type indium phosphide may be used. For impurity, for example, zinc (Zn) or the like may be used.

The GaInPAs cell 120 is formed on a surface of the InP substrate 110. The GaInPAs cell 120 includes a p-type InP layer 121, a p-type Ga(x)InP(y)As layer 122, an n-type Ga(x)InP(y)As layer 123, and an n-type [Al(x)Ga](y)InAs layer 124.

The GaInPAs cell 120 is configured with crystalline layers of GaInPAs which lattice match with InP. The InP layer 121, the Ga(x)InP(y)As layer 122, the Ga(x)InP(y)As layer 123 and the [Al(x)Ga](y)InAs layer 124 are laminated in this order.

The InP layer 121 is a BSF (Back Surface Field) layer arranged on a deep side in the light incident direction. A p-n junction in the GaInPAs cell 120 is structured by the Ga(x)InP(y)As layer 122 and the Ga(x)InP(y)As layer 123. The [Al(x)Ga](y)InAs layer 124 is a window layer arranged on a near side in the light incident direction (light incident side).

Here, the GaInPAs cell 120 may be regarded as a cell, which is configured with the Ga(x)InP(y)As layer 122 and the Ga(x)InP(y)As layer 123 that structure the p-n junction, on the light incident side of the GaInPAs cell 120 the [Al(x)Ga](y)InAs layer 124 is formed, and on the deep side in the light incident direction the InP layer 121 is formed.

The InP layer 121 has a band gap greater than a band gap (1.0 eV) of the p-type Ga(x)InP(y)As layer 122 and the n-type Ga(x)InP(y)As layer 123, since the InP layer 121 is used as the BSF layer. For the impurity of the InP layer 121, for example, zinc (Zn) may be used.

In the Ga(x)InP(y)As layer 122, for example, by using Zn for the impurity, a conductivity type becomes p-type.

In the Ga(x)InP(y)As layer 123, for example, by using Si for the impurity, a conductivity type becomes n-type.

In the Ga(x)InP(y)As layer 122 and the Ga(x)InP(y)As layer 123, a ratio of Ga, x, and a ratio of P, y, are adjusted so that the band gaps are 1.0 eV.

The [Al(x)Ga](y)InAs layer 124 has a band gap greater than the band gaps (1.0 eV) of the Ga(x)InP(y)As layer 122 and the Ga(x)InP(y)As layer 123, since the [Al(x)Ga](y)InAs layer 124 is used as a window layer.

In the first embodiment, the band gap of the [Al(x)Ga](y)InAs layer 124 is set to 1.5 eV, for example. For the impurity of the [Al(x)Ga](y)InAs layer 124, for example, Si may be used.

Since AlGaInAs lattice matches with InP, it is suitable for being laminated on the Ga(x)InP(y)As layer 123.

The junction layer 130 is joined to the junction layer 140 in the process of manufacturing the compound-semiconductor photovoltaic cell 100 by a cleaning treatment and a surface activation treatment. The compound-semiconductor photovoltaic cell 100 is manufactured by joining the two laminated bodies.

The junction layer 130 is formed on an uppermost surface of one of the two laminated bodies, and the junction layer 140 is formed on an uppermost surface of the other laminated body. By joining the junction layer 130 and the junction layer 140, the compound-semiconductor photovoltaic cell 100, as shown in Fig. 1, is manufactured.

As the junction layer 130, an n⁺-type InP layer is used. An impurity concentration of the junction layer 130 is set to be higher than an impurity concentration of the [Al(x)Ga](y)InAs layer 124. Therefore, a conductivity type of the junction layer 130 is n⁺-type.

A band gap of the InP layer used as the junction layer 130 is 1.35 eV. Here, an embodiment in which the band gap of the InP layer used as the junction layer 130 is 1.35 eV will be explained. However, a Ga(x)InP layer in which Ga is added may be used as the junction layer 130, and the band gap may be made greater than 1.35 eV by increasing a composition ratio of Ga.

A material used for the junction layer 130 preferably has a band gap which is greater than or equal to the band gap (1.42 eV) of the GaAs cell 160 which is arranged on an incident side (upstream side) of the junction layer 130 in the light incident direction.

Moreover, a band gap of the [Al(x)Ga](y)InAs layer 124 which is a window layer of the GaInPAs cell 120 is set to 1.5 eV, for example, so that light transmitted through the junction layer 130 surely reaches the Ga(x)InP(y)As layer 122 and the Ga(x)InP(y)As layer 123 of the GaInPAs cell 120.

The junction layer 140 is joined to the junction layer 130 on the side of the InP substrate 110 in the process of manufacturing the compound-semiconductor photovoltaic cell 100 by a cleaning treatment and a surface activation treatment. As the junction layer 140, an n⁺-type GaPAs layer may be used. A band gap of the GaPAs layer is greater than the band gap (1.42 eV) of the GaAs cell 160.

The GaPAs layer applies a tensile strain to the GaAs substrate, but there is not a problem when it is within a range of critical film thickness, and it can be used as the junction layer 140. An impurity concentration of the junction layer 140 is set in the same way as the junction layer 130. The band gap of the GaPAs is 1.47 eV.

Since a part above the boundary of the junction layers 130 and 140 of the compound-semiconductor photovoltaic cell 100 shown in Fig. 1 is manufactured, for example, by serially laminating in a state of being turned upside down, the junction layer 140 is laminated on the GaAs cell 160.

The GaAs cell 160 is formed between the junction layer 140 and the tunnel junction layer 170.

The GaAs cell 160 includes a p-type Ga(x)InP layer 161, a p-type GaAs layer 162, an n-type GaAs layer 163 and an n-type [Al(x)Ga](y)InP layer 164.

The Ga(x)InP layer 161, the GaAs layer 162, the GaAs layer 163 and the [Al(x)Ga](y)InP layer 164 have a configuration of being laminated on a surface of the junction layer 140 in this order. The GaAs cell 160 is, in an actual manufacturing process, for example, laminated on the tunnel junction layer 170 in a state of being turned upside down.

For this reason, in the actual manufacturing process, they are laminated on the tunnel junction layer 170 in the order of, for example, the [Al(x)Ga](y)InP layer 164, the GaAs layer 163, the GaAs layer 162 and the Ga(x)InP layer 161.

The Ga(x)InP layer 161 is a BSF (Back Surface Field) layer arranged on a deep side in the light incident direction. A p-n junction in the GaAs cell 160 is structured by the GaAs layer 162 and the GaAs layer 163. The [Al(x)Ga](y)InP layer 164 is a window layer arranged on a near side in the light incident direction (light incident side).

Here, the GaAs cell 160 may be regarded as a cell, which is configured with the GaAs layer 162 and the GaAs layer 163 that structure the p-n junction, on the light incident side of the GaAs cell 160 the [Al(x)Ga](y)InP layer 164 is formed, and on the deep side in the light incident direction the Ga(x)InP layer 161 is formed.

The Ga(x)InP layer 161 has only to have a band gap greater than or equal to a band gap (1.42 eV) of the p-type GaAs layer 162 and the n-type GaAs layer 163, since the Ga(x)InP layer 161 is used as the BSF layer. For the impurity of the Ga(x)InP layer 161, for example, Zn may be used.

In the GaAs layer 162, for example, by using Zn for the impurity, a conductivity type becomes p-type.

In the GaAs layer 163, for example, by using Si for the impurity, a conductivity type becomes n-type.

The band gaps of the GaAs layer 162 and the GaAs layer 163 are 1.42 eV.

The [Al(x)Ga](y)InP layer 164 has a band gap greater than the band gaps (1.42 eV) of the p-type GaAs layer 162 and the n-type GaAs layer 163, since the [Al(x)Ga](y)InP layer 164 is used as a window layer.

In the first embodiment, the [Al(x)Ga](y)InP layer 164 has only to have a band gap greater than or equal to the band gap (1.42 eV) of the p-type GaAs layer 162 and the n-type GaAs layer 163. For the impurity of the [Al(x)Ga](y)InP layer 164, for example, Si may be used.

The tunnel junction layer 170 is arranged between the GaAs cell 160 and the GaInP cell 180. A part above the boundary of the junction layers 130 and 140 of the compound-semiconductor photovoltaic cell 100 shown in Fig. 1 is manufactured, for example, by serially laminating in a state of being turned upside down, the tunnel junction layer 170 is laminated on the GaInP cell 180.

The tunnel junction layer 170 includes an n-type Ga(x)InP layer 171, and a p-type Al(x)GaAs layer 172. For an impurity for causing a conductivity type to become n-type, for example, tellurium (Te) may be used. For an impurity for causing a conductivity type to become p-type, for example, carbon (C) may be used. The n-type Ga(x)InP layer 171 and the p-type Al(x)GaAs layer 172 form a thin p-n junction which is doped at high concentration.

Both the Ga(x)InP layer 171 and the Al(x)GaAs layer 172 are doped at higher concentration than the GaInP cell 180. The tunnel junction layer 170 is a junction layer arranged so that an electric current flows between the p-type Ga(x)InP layer 182 in GaInP cell 180 and the n-type GaAs layer 163 in the GaAs cell 160 by the tunnel junction.

The GaInP cell 180 is formed between the tunnel junction layer 170 and the contact layer 40A.

The GaInP cell 180 includes a p-type Al(x)InP layer 181, a p-type Ga(x)InP layer 182, an n-type Ga(x)InP layer 183 and an n-type Al(x)InP layer 184.

The Al(x)InP layer 181, the Ga(x)InP layer 182, the Ga(x)InP layer 183 and the Al(x)InP layer 184 are laminated on a surface of the tunnel junction layer 170 in this order. The GaInP cell 180 is, in an actual manufacturing process, for example, laminated on a GaAs contact layer 40A on a GaAs substrate, which is not shown, in a state of being turned upside down.

The GaInP cell 180 is configured with crystalline layers of GaInP which lattice matches with GaAs. In an actual manufacturing process, for example, the Al(x)InP layer 184, the Ga(x)InP layer 183, the Ga(x)InP layer 182 and the Al(x)InP layer 181 are laminated in this order.

The Al(x)InP layer 181 is a BSF (Back Surface Field) layer arranged on a deep side in the light incident direction. A p-n junction in the GaInP cell 180 is structured by the Ga(x)InP layer 182 and the Ga(x)InP layer 183. The Al(x)InP layer 184 is a window layer arranged on a near side in the light incident direction (light incident side).

Here, the GaInP cell 180 may be regarded as a cell, which is configured with the Ga(x)InP layer 182 and the Ga(x)InP layer 183 that structure the p-n junction, on the light incident side of which the Al(x)InP layer 184 is formed, and on the deep side of which in the light incident direction the Al(x)InP layer 181 is formed.

The Al(x)InP layer 181 only has to have a band gap greater than or equal to a band gap (1.9 eV) of the p-type Ga(x)InP layer 182 and the n-type Ga(x)InP layer 183, since the Al(x)InP layer 181 is used as the BSF layer. For the impurity of the Al(x)InP layer 181, for example, Zn may be used.

In the Ga(x)InP layer 182, for example, by using Zn for the impurity, a conductivity type becomes p-type.

In the Ga(x)InP layer 183, for example, by using Si for the impurity, a conductivity type becomes n-type.

The band gaps of the Ga(x)InP layer 182 and the Ga(x)InP layer 183 are 1.9 eV.

The Al(x)InP layer 184 has a band gap greater than the band gaps (1.9 eV) of the p-type Ga(x)InP layer 182 and the n-type Ga(x)InP layer 183, since the Al(x) InP layer 184 is used as a window layer.

In the first embodiment, the Al(x)InP layer 184 has only to have a band gap greater than or equal to the band gap (1.9 eV) of the p-type Ga(x)InP layer 182 and the n-type Ga(x)InP layer 183. For the impurity of the Al(x)InP layer 184, for example, Si may be used.

The contact layer 40A is a layer laminated on the GaInP cell 180 in order to perform an ohmic connection to the electrode 50. For example, a gallium arsenide (GaAs) layer is used for the contact layer 40A.

The electrode 50 is, for example, a metallic thin film, such as Ti/Pb/Au, and formed on the contact layer 40A.

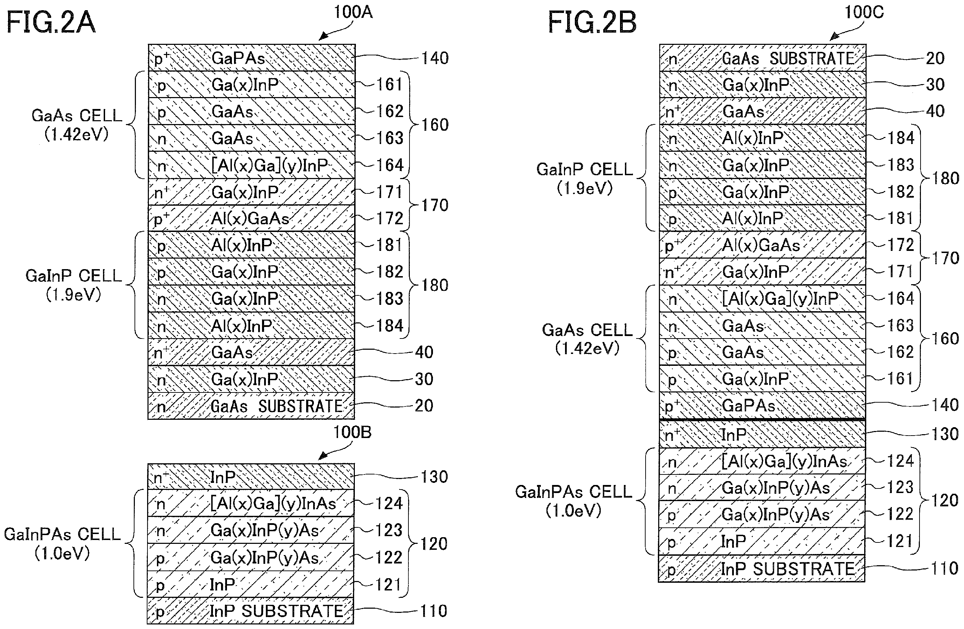

Next, a manufacturing method of the compound-semiconductor photovoltaic cell 100 according to the first embodiment will be explained with reference to Figs. 2A to 3B.

Figs. 2A to 3B are diagrams illustrating the manufacturing method of the compound-semiconductor photovoltaic cell 100 according to the first embodiment.

At first, as shown in Fig. 2A, a laminated body 100B is manufactured using an InP substrate 110, while manufacturing a laminated body 100A using a GaAs substrate 20. The GaAs substrate 20 is an example of a second compound-semiconductor substrate.

Here, a GaInP cell 180 included in the laminated body 100A is configured with crystalline layers of GaInP which lattice match with GaAs, and is formed on the GaAs substrate 20. Moreover, a GaInPAs cell 120 included in the laminated body 100B is configured with crystalline layers of GaInPAs which lattice matches with InP, and is formed on the InP substrate 110.

In this way, lattice constants of the laminated body 100A and the laminated body 100B are different from each other. The compound-semiconductor photovoltaic cell 100 according to the first embodiment is manufactured by directly joining the laminated body 100A and the laminated body 100B, lattice constants of which are different from each other.

Since the lattice constant of InP is about 0.587 nm or 5.87 Å (angstroms), it is only necessary to adjust a composition so that the GaInPAs cell 120 formed on the InP substrate 110 has a lattice constant quite close to the lattice constant (about 5.87 Å) of InP.

Moreover, since the lattice constant of GaAs is about 0.565 nm or 5.65 Å, it is only necessary to adjust compositions so that a GaAs cell 160 and a GaInP cell 180, which are formed on the GaAs substrate 20, have lattice constants quite close to the lattice constant (about 5.65 Å) of GaAs.

The laminated body 100A is manufactured by laminating, using MOCVD (Metal Organic Chemical Vapor Deposition) method, on the GaAs substrate 20, a Ga(x)InP etching stop layer 30, an n⁺-type GaAs contact layer 40, the GaInP cell 180, the tunnel junction layer 170, the GaAs cell 160 and the junction layer 140.

Here, the GaInP cell 180 includes an Al(x)InP layer 184 which lattice matches with GaAs, a Ga(x)InP layer 183, a Ga(x)InP layer 182 and an Al(x)InP layer 181. The Al(x)InP layer 181 is a BSF layer, and the Al(x)InP layer 184 is a window layer.

Moreover, the tunnel junction layer 170 includes an Al(x)GaAs layer 172 and an Ga(x)InP layer 171.

The GaAs cell 160 includes an [Al(x)Ga](y)InP layer 164, a GaAs layer 163, a GaAs layer 162 and a Ga(x)InP layer 161. The Ga(x)InP layer 161 is a BSF layer, and the [Al(x)Ga](y)InP layer 164 is a window layer.

Upon the lamination (growth) of the laminated body 100A, the lower side having the GaAs substrate 20 is a light incident side. Since the laminated body 100A is turned upside down upon joining to the laminated body 100B later, the laminated body 100A grows from an opposite direction with respect to the vertical relationship shown in Fig. 1.

Specifically, it serially grows from a cell of a wide band gap (GaInP cell 180) to a narrow gap cell (GaAs cell 160). Moreover, finally a p-side becomes the lower side (deep side in the light incident direction).

Moreover, for the laminated body 100B, the GaInPAs cell 120 and the junction layer 130 are laminated (grown) on the InP substrate 110 by MOCVD method. In the laminated body 100B shown in Fig. 2A, a side of the junction layer 130, which is opposite to the InP substrate 110, is a light incident side.

The GaInPAs cell 120 includes, from a side of the InP substrate 110, an InP layer 121, a Ga(x)InP(y)As layer 122, a Ga(x)InP(y)As layer 123 and an [Al(x)Ga](y)InAs layer 124. The InP layer 121 is a BSF layer, and the [Al(x)Ga](y)InAs layer 124 is a window layer.

As described above, the laminated bodies 100A and 100B are manufactured through epitaxial growth by MOCVD method.

Next, as shown in Fig. 2B, the laminated bodies 100A and 100B which are manufactured through epitaxial growth are joined directly.

Surfaces of the junction layer 140 of the laminated body 100A and the junction layer 130 of the laminated body 100B are subjected to a cleaning treatment and a surface activation treatment, and the junction layer 130 and the junction layer 140 are joined directly. The surface activation treatment is performed by a nitrogen (N₂) plasma treatment, and the junction is performed in a vacuum at temperature of 150 °C.

According to the above-described processes, a laminated body 100C, as shown in Fig. 2B, is prepared. The laminated body 100C is manufactured by placing the laminated body 100A, which is turned upside down, i.e. in a state where the junction layer 140 is on the bottom side, on the junction layer 130 of the laminated body 100B, shown in Fig. 2A, and joining the junction layer 130 and the junction layer 140.

The laminated body 100C has a configuration in which on the InP substrate 110, the GaInPAs cell 120, the junction layer 130, the junction layer 140, the GaAs cell 160, the tunnel junction layer 170, the GaInP cell 180, the GaAs contact layer 40, an InP etching stop layer 30 and the GaAs substrate 20 are laminated in this order.

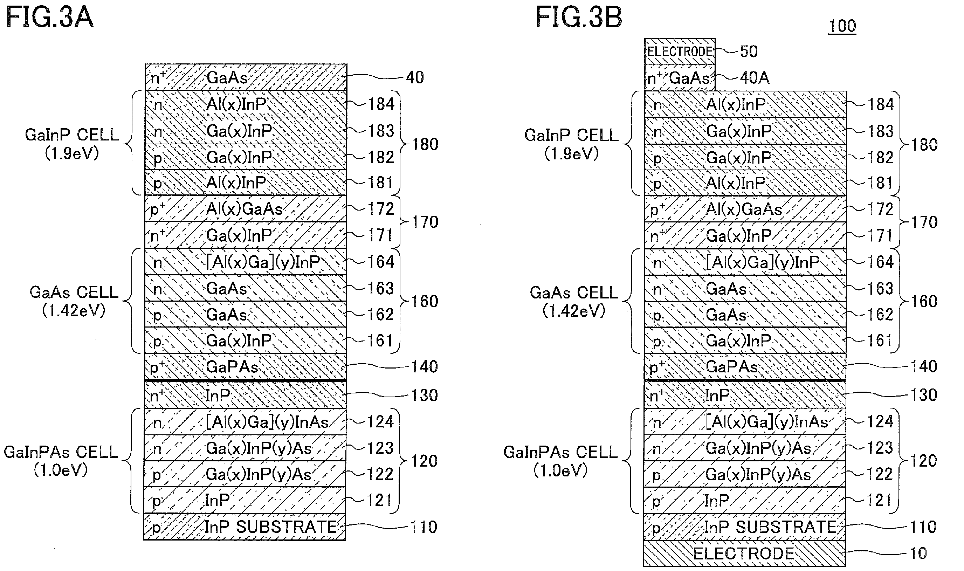

Next, the GaAs substrate 20 and the GaInP etching stop layer 30 are removed from the laminated body 100C, shown in Fig. 2B by selective etching, respectively, and thereby a laminated body 100D, shown in Fig. 3A, is obtained.

The GaAs substrate 20 and the GaInP etching stop layer 30 may be etched as follows:
The GaAs substrate 20 can be etched, for example, with a mixture of sulfuric acid (H₂SO₄), hydrogen peroxide (H₂O₂) and water (H₂O) as wet etching solution. Since GaInP in the GaInP etching stop layer 30 does not dissolve in the mixture of sulfuric acid (H₂SO₄), hydrogen peroxide (H₂O₂) and water (H₂O), the wet etching process can be stopped at the GaInP etching stop layer 30.

Moreover, the GaInP etching stop layer 30 can be etched, for example, with a mixture of hydrochloric acid (HCl) and water (H₂O),

As described above, the laminated body 100D, shown in Fig. 3A, is obtained by removing the GaAs substrate 20 and the GaInP etching stop layer 30 from the laminated body 100C (See Fig. 2B) by selective etching, respectively.

Next, while forming an upper electrode 50 (see Fig. 1) on the GaAs contact layer 40, a lower electrode 10 is formed on the InP substrate 110.

Then, the contact layer 40 (See Fig. 3A) other than a part located immediately below the upper electrode 50 (See Fig. 1) is removed by using the upper electrode 50 as a mask, and thereby a contact layer 40A, as shown in Fig. 3B, is formed.

The contact layer 40A can be formed, for example, by etching with a mixture of sulfuric acid (H₂SO₄), hydrogen peroxide (H₂O₂) and water (H₂O) as wet etching solution. Since AlInP in the Al(x)InP layer 184 does not dissolve in the mixture of sulfuric acid (H₂SO₄), hydrogen peroxide (H₂O₂) and water (H₂O), the wet etching process can be stopped at the Al(x)InP layer 184 in the GaInP cell 180.

As described above, the compound-semiconductor photovoltaic cell 100 according to the first embodiment is completed. The compound-semiconductor photovoltaic cell 100 shown in Fig. 3B is identical with the compound-semiconductor photovoltaic cell 100 shown in Fig. 1.

The compound-semiconductor photovoltaic cell 100 has a configuration such that solar light enters the compound-semiconductor photovoltaic cell 100 from a side of a cell of a wide band gap (side of the GaInP cell 180). Meanwhile, an antireflection film is preferably provided on a surface of the Al(x)InP layer 184, which solar light enters. The antireflection film is omitted in Fig. 3B.

As described above, the compound-semiconductor photovoltaic cell 100 according to the first embodiment uses the GaPAs layer which is greater than the band gap (1.42 eV) of the GaAs cell 160 as a junction layer 140.

Conventionally, GaAs (1.42 eV) or GaInP (1.9 eV) is used as a wafer junction layer such as the junction layer 140. In a case of a GaAs wafer junction layer, a part of light transmitted through the GaAs cell (1.42 eV) is absorbed here, and efficiency decreases.

On the other hand, in the first embodiment, for a material of the junction layers 130 and 140 which serve both as wafer junction layers and as tunnel junctions, p⁺GaPAs/n⁺InP is used. Since GaPAs as the junction layer 140 has a band gap greater than the GaAs cell 160 (1.42 eV), it is possible to cause most of light of long wavelength transmitted through the GaAs cell 160 to enter the GaInPAs cell 120.

Moreover, impurity concentrations of the tunnel junction layers and the wafer junction layers are required to be high. In the first embodiment, since the junction layer 130 and 140 serve both as the tunnel junction layers and the wafer junction layers between the GaAs cell 160 and the GaInPAs cell 120, a thickness of high concentration layers can be decreased and light absorption in the junction layers 130 and 140 is reduced. Therefore, a highly-efficient compound-semiconductor photovoltaic cell 100 can be manufactured.

Moreover, the GaInP cell 180 (1.9 eV) lattice matching with GaAs has a great junctional resistance in joining to InP, and is a factor degrading efficiency. In the first embodiment of the present invention, since difference between valence band energy of p⁺GaPAs of the junction layer 140 and conduction band energy of n⁺InP of the junction layer 130 is less than the difference between valence band energy of p⁺GaInP and the conduction band energy of n⁺InP, the junctional resistance is low. According to the above-described property, it is possible to further enhance the efficiency.

Moreover, in the compound-semiconductor photovoltaic cell 100 according to the first embodiment, as a window layer of the GaInPAs cell 120 formed on the InP substrate 110, the [Al(x)Ga](y)InAs layer 124 with a band gap of 1.5 eV is formed, and as the junction layer 130 above it, the InP junction layer is formed.

Moreover, a band gap of the [Al(x)Ga](y)InAs layer 124 which is a window layer of the GaInPAs cell 120 is set to 1.5 eV, which is greater than the GaAs cell 160, so that light transmitted through the junction layer 130 surely reaches the Ga(x)InP(y)As layer 122 and the Ga(x)InP(y)As layer 123 of the GaInPAs cell 120.

For this reason, according to the first embodiment, a compound-semiconductor photovoltaic cell 100 for which efficiency is enhanced and a manufacturing method of the compound-semiconductor photovoltaic cell 100 can be provided.

Moreover, in the compound-semiconductor photovoltaic cell 100 according to the first embodiment, in addition to setting the band gap of the junction layer 130 as described above, a band gap of the [Al(x)Ga](y)InAs layer 124, which is a window layer of the GaInPAs cell 120, is set to 1.5 eV which is greater than that of the GaAs cell 160.

Also according to the above setting, efficiency is enhanced for the compound-semiconductor photovoltaic cell 100.

Moreover, instead of the [Al(x)Ga](y)InAs layer 124, which is a window layer of the GaInPAs cell 120, a thin film layer formed of Al(Ga)InAs, Al(Ga)AsSb, Al(Ga)PSb, Al(In)PSb or the like may be used.

In this case, instead of the [Al(x)Ga](y)InAs layer 124, it is only necessary to adjust a composition so that the thin film layer of Al(Ga)InAs, Al(Ga)AsSb, Al(Ga)PSb, Al(In)PSb or the like has a band gap the same as or greater than the GaAs cell 160 (1.42 eV).

Meanwhile, in the expressions "Al(Ga)InAs", "Al(Ga)AsSb" and "Al(Ga)PSb", the notation "(Ga)" represents both a composition including Ga and a composition not including Ga. That is, "Al(Ga)InAs" is an expression including "AlGaInAs" and "AlInAs". Moreover, "Al(Ga)AsSb" is an expression including "AlGaAsSb" and "AlAsSb". Furthermore, "Al(Ga)PSb" is an expression including "AlGaPSb" and "AlPSb".

Moreover, in the expression "Al(In)PSb", the notation "(In)" represents both a composition including In and a position not including In. That is, "Al(In)PSb" is an expression including "AlInPSb" and "AlPSb".

Regarding a triple-junction photovoltaic cell 100, such as the compound-semiconductor photovoltaic cell 100 according to the first embodiment, for example, Oyo Butsuri Vol. 79, No. 5, 2010, P. 436 describes, as band gaps of three cells, a combination of 1.9 eV/1.42 eV/1.0 eV and a combination of 1.7 eV/1.2 eV/0.67 eV, which are more preferable than the triple-junction cell of (1.88 eV/1.4 eV/0.67 eV) according to the related art.

However, it is quite difficult to realize the above-described combinations of band gaps by using a lattice constant.

In this respect, according to the first embodiment, since a compound-semiconductor photovoltaic cell 100 is manufactured by joining two cells of lattice constants (laminated body 100A and laminated body 100B (See Fig. 2A)) using a direct junction method, the compound-semiconductor photovoltaic cell 100 including cells having lattice constants which are different from each other can be easily realized.

Meanwhile, in the above description, the embodiment, in which respective cells or the like are formed on an InP substrate 10 and a GaAs substrate 20 by MOCVD method, is explained. However, the respective cells or the like may be formed by MBE (Molecular Beam Epitaxy) method.

Moreover, in the above description, the embodiment, in which the compound-semiconductor photovoltaic cell 100 is manufactured by using laminated bodies 100B and 100A, using the InP substrate 10 and the GaAs substrate 20, respectively, is explained. However, a combination other than the InP substrate 10 and the GaAs substrate 20 may be used.

For example, the laminated bodies 100B and 100A may be manufactured similarly by a combination of a Ge substrate and an InP substrate, a combination of a gallium antimonide (GaSb) substrate and a GaAs substrate, a combination of GaSb substrate and a Ge substrate, a combination of a Si substrate and a Ge substrate, a combination of a Si substrate and a GaAs substrate or the like.

Moreover, in the above description, the embodiment, in which as an InP lattice matching system material cell a GaInPAs cell 120 is used, is explained. However, the InP lattice matching system material cell is not limited to the GaInPAs cell 120, but a cell expressed by "GaIn(P)As" may be used.

The notation (P) in the expression GaIn(P)As represents both a composition including P and a composition not including P. That is, GaIn(P)As is an expression including both GaInPAs and GaInAs. Therefore, a GaInAs cell may be used instead of the GaInPAs cell 120.

Moreover, in the above description, the embodiment, in which as a GaAs lattice matching system material cell a GaInP cell 180 is used, is explained. However, the GaAs lattice matching system material cell is not limited to the GaInP cell 180, but a cell expressed by "(Al)GaInP(As)" may be used.

The expression "(Al)GaInP(As)" includes both a composition including Al and a composition not including Al. Moreover, the expression "(Al)GaInP(As)" includes both a composition including As and a composition not including As. For this reason, it is expressed by "(Al)" and "(As)". That is, "(Al)GaInP(As)" is an expression including AlGaInP, GaInPAs and GaInP. Therefore, an AlGaInP cell or a GaInPAs cell may be used instead of the GaInP cell 180.

### <Second embodiment>

In a photovoltaic cell shown in Applied Physics Letters, 101, 191111 (2012), light of long wavelength transmitted through the GaInPAs cell (1.8 eV) enters a GaInPAs cell (1.15 eV). However, on the light incident side of the GaInPAs cell (1.15 eV), an InP junction layer whose band gap is less than an absorption layer (1.8 eV) of the GaInPAs cell is formed via a Pd layer below the GaInPAs cell (1.8 eV).

Therefore, before entering the GaInPAs cell (1.15 eV) a part of light is absorbed in the InP junction layer. This InP junction layer serves both a function as a junction layer and a function as a window layer. However, since such an InP window layer has a band gap less than the absorption layer (1.8 eV) of the GaInPAs cell, it contributes to degradation of efficiency of the photovoltaic cell.

Moreover, in the related art described in publication of US Patent Application No. 2012/0138116, light of long wavelength transmitted through the GaInP cell enters the GaInAs cell. However, on the light incident side of the GaInAs cell, an InP junction layer whose band gap is less than the GaInP is formed as a junction layer which is directly connected to a GaAs epi-substrate. Therefore, before entering the GaInAs cell a part of light is absorbed in the InP junction layer. Such an InP window layer contributes to degradation of efficiency of the photovoltaic cell.

In the second embodiment, a compound-semiconductor photovoltaic cell that also solves the above-described problem is provided.

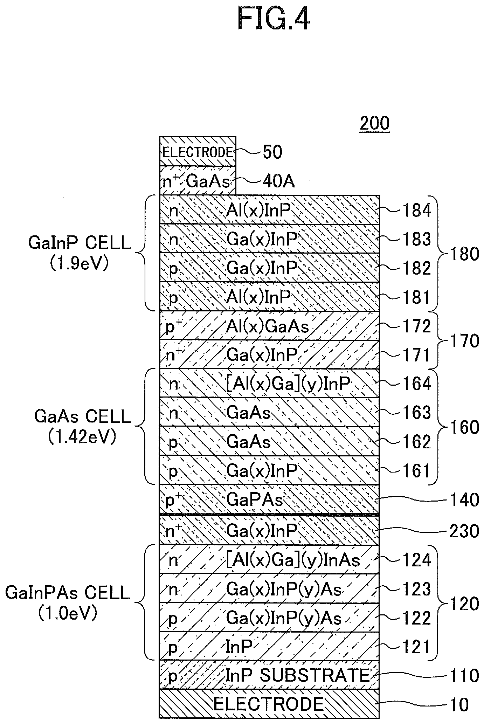

Fig. 4 is a cross-sectional diagram illustrating a compound-semiconductor photovoltaic cell 200 according to the second embodiment. The compound-semiconductor photovoltaic cell 200 is obtained by replacing the junction layer 130 (InP layer) in the compound-semiconductor photovoltaic cell 100 according to the first embodiment by a junction layer 230 (Ga(x)InP layer). Since other configurations are the same as the compound-semiconductor photovoltaic cell 100 according to the first embodiment, a difference will be explained in the following.

As the junction layer 230, an n⁺-type Ga(x)InP layer is used. An impurity concentration of the junction layer 230 is set to be higher than an impurity concentration of the [Al(x)Ga](y)InAs layer 124. Therefore, a conductivity type of the junction layer 230 is n⁺-type.

The Ga(x)InP layer used as the junction layer 230 is, for example, a GaInP layer with a Ga composition of 10% (i.e. x=0.1), a tensile strain of 0.7% and a band gap of 1.42 eV.

Here, an embodiment in which the band gap of the Ga(x)InP layer used as the junction layer 230 is 1.42 eV will be explained. However, the band gap of the Ga(x)InP layer used as the junction layer 230 may be made greater than 1.42 eV by increasing the composition ratio of Ga.

The Ga(x)InP layer used as the junction layer 230 only has to have a band gap which is greater than or equal to the band gap (1.42 eV) of the GaAs cell 160 which is arranged on an incident side (upstream side) of the junction layer 230 in the light incident direction.

That is, the band gap of the junction layer 230 only has to be greater than or equal to the band gap of the GaAs cell 160 which is arranged on the incident side (upstream side) of the junction layer 230 in the light incident direction.

In the compound-semiconductor photovoltaic cell 200 according to the second embodiment, the band gap of the junction layer 230 is set as above in order to prevent light transmitted through the GaAs cell 160 and the junction layer 140 without absorption from being absorbed in the junction layer 230.

That is, the above-described setting is to effectively guide solar light to the GaInPAs cell 120 on a deep side (downstream side) of the junction layer 230 in the light incident direction without being absorbed in the junction layer 230.

In the compound-semiconductor photovoltaic cell 200 according to the second embodiment, as a window layer of the GaInPAs cell 120 formed on the InP substrate 110, an [Al(x)Ga](y)InAs layer 124 with a band gap of 1.5 eV is formed, and as the junction layer 230 further on it a GaInP junction layer is formed.

The GaInP junction layer used as the junction layer 230 is a GaInP junction layer which has a Ga composition of 10%, a tensile strain of 0.7% and a band gap of 1.42 eV. The band gap of the junction layer 230 (1.42 eV) is set so as to be greater than or equal to a band gap (1.42 eV) of the GaAs call 160 which is a photoelectric conversion cell adjacent to the junction layer 230 on the light incident side.

That is, the Ga(x)InP layer used as the junction layer 230 has the above-described band gap in order to guide light transmitted through the GaAs cell 160, which is a photoelectric conversion cell adjacent on the light incident side (upstream side) of the junction layer 230 in the light incident direction, without being absorbed, to the GaInPAs cell 120 on the deep side of the junction layer 230 in the light incident direction.

Moreover, a band gap of the [Al(x)Ga](y)InAs layer 124 which is a window layer of the GaInPAs cell 120 is set to 1.5 eV, which is greater than the GaAs cell 160, so that light transmitted through the junction layer 230 surely reaches the Ga(x)InP(y)As layer 122 and the Ga(x)InP(y)As layer 123 of the GaInPAs cell 120.

In the compound-semiconductor photovoltaic cell 200 according to the second embodiment, a Ga(x)InP layer having a band gap greater than or equal to the band gaps of the GaAs cell 160 and the junction layer 140 is used as the junction layer 230 in order to suppress an occurrence of energy loss.

For this reason, according to the second embodiment, a compound-semiconductor photovoltaic cell 200 for which efficiency is enhanced and a manufacturing method of the compound-semiconductor photovoltaic cell 200 can be provided.

Moreover, in the compound-semiconductor photovoltaic cell 200 according to the second embodiment, a band gap of the [Al(x)Ga](y)InAs layer 124, which is a window layer of the GaInPAs cell 120, is set to 1.5 eV which is greater than that of the GaAs cell 160.

Also according to the above setting, efficiency is enhanced for the compound-semiconductor photovoltaic cell 200.

Moreover, the GaInP layer (junction layer 230) having a tensile strain is formed with a thickness less than the thickness in which a lattice relaxation occurs.

Moreover, as a material, which has a band gap being the same or more than the GaAs cell 160 (1.42 eV) and which can be grown to the InP substrate 110, there is GaPSb, which can lattice match, other than the GaInP having tensile strain.

For this reason, as the junction layer 230, instead of the above-described GaInP layer, a GaPSb layer may be used. In this case, a composition only has to be adjusted so that the GaPSb layer has a band gap being the same or more than the GaAs cell 160 (1.42 eV).

Moreover, Al(Ga)InAs, Al(Ga)AsSb, Al(Ga)PSb, Al(In)PSb or the like is also a material which has a composition to have a band gap being the same or more than the GaAs cell 160 (1.42 eV) and which can be grown on the InP substrate 110.

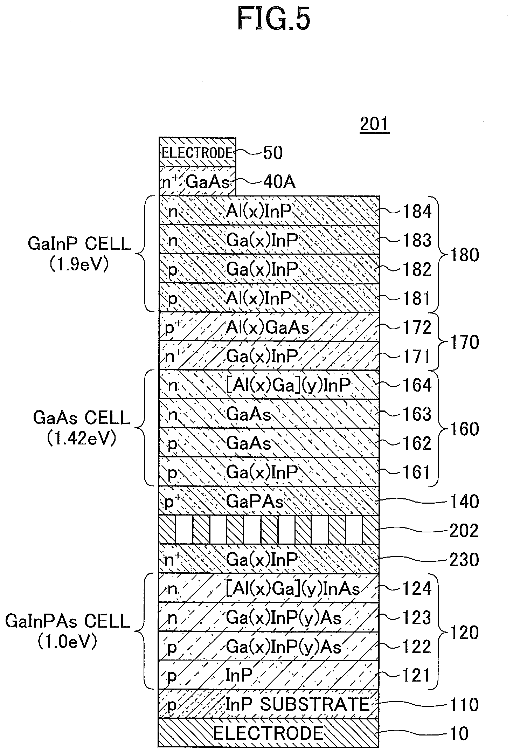

Fig. 5 is a cross-sectional diagram illustrating a compound-semiconductor photovoltaic cell 201 according to a variation of the second embodiment.

The compound-semiconductor photovoltaic cell 201 according to the variation of the second embodiment is obtained by mechanically joining the junction layers 230 and 140 shown in Fig. 4.

In the compound-semiconductor photovoltaic cell, shown in Fig. 5, a fixture member 202 joins between the junction layers 230 and 140. As the fixture member 202, for example, a palladium (Pd) nanoparticle array may be used.

In the palladium nanoparticle array, conductive nanoparticles are self-arranged on a junction interface using a phase separation array of block copolymer. A nano-array of Pd, Au, Pt, Ag or the like is possible. By spin coating diluted solution of block copolymer, self-arranging the block copolymer and exposing to aqueous solution including metal ions such as Pd²⁺ (palladium), metal ions are selectively formed on the block copolymer. Then, by irradiating argon (Ar) plasma, a block copolymer template is removed and a self-arranged nanoparticle array is formed. Light is transmitted in a part without nano particles. By using the palladium nanoparticle array, light transmitted through the GaAs cell 160 can be effectively guided to the GaInPAs cell 120.

By joining the junction layers 130 and 140 in a state in which a palladium nanoparticle array is formed on the junction layer 130 or 140, the compound-semiconductor photovoltaic cell 201 can be manufactured.

The fixture member 202 is an example of a fixture unit. In this way, a joining method of mechanically overlaying two laminated bodies using the fixture member 202 is called "mechanical stack".

Meanwhile, the fixture member 202 is not limited to the palladium nanoparticle array, but may be a nanoparticle array including another metal (e.g. gold (Au)). Furthermore, other mechanical means may be employed.

As described above, a laminated body including the GaInPAs cell 120 and a laminated body including the GaAs cell 160 and the GaInP cell 180 may be joined by the mechanical stack.

### <Third embodiment>

The first and second embodiments show the configuration in which the junction layers 130, 140 or the junction layers 230, 140 serve both as wafer junction layers and as tunnel junction layers. However, the wafer junction layers and the tunnel junction layers may be formed separately.

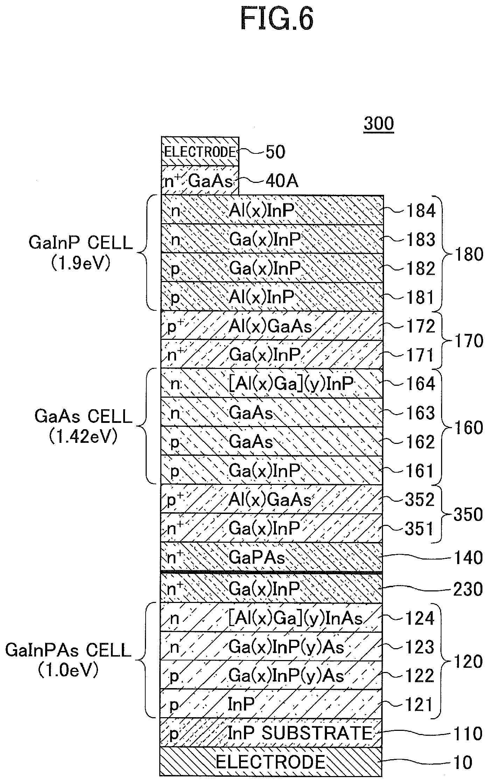

Fig. 6 is a cross-sectional diagram illustrating a compound-semiconductor photovoltaic cell 300 according to the third embodiment. The compound-semiconductor photovoltaic cell 300 is obtained by providing a tunnel junction layer 350 between the junction layer 140 and the GaAs cell 160 of the compound-semiconductor photovoltaic cell 200 according to the second embodiment. Since other configurations are the same as the compound-semiconductor photovoltaic cell 200 according to the second embodiment, a difference will be explained in the following.

The tunnel junction layer 350 includes an n⁺GaInP layer 351 and a p⁺AlGaAs 352. The n⁺GaInP layer 351 and the p⁺AlGaAs 352 form a tunnel junction layer including a thin p-n junction which is doped at high concentration.

In the compound-semiconductor photovoltaic cell 300, the junction layer 140 and the junction layer 230 realize a wafer junction. Moreover, a tunnel junction layer 350 is provided between the junction layer 140 and the GaAs cell 160, in the same way as the tunnel junction layer 170 between the GaInP cell 180 and the GaAs cell 160.

Meanwhile, as the tunnel junction layer 350, a tunnel junction layer of p⁺GaAs and n⁺GaAs may be used. However, since both the n⁺GaInP layer 351 and the p⁺AlGaAs 352 have band gaps greater than the GaAs cell 160, it is possible to cause most of light of long wavelength transmitted through the GaAs cell 160 to enter the GaInPAs cell 120.

As described above, according to the third embodiment, a compound-semiconductor photovoltaic cell 300 for which efficiency is enhanced can be provided.

### <Fourth embodiment>

In the third embodiment, the triple-junction type compound-semiconductor photovoltaic cell 300 including the GaInP cell 180, the GaAs cell 160 and the GaInPAs cell 120 is manufactured. A combination of band gaps of the three photoelectric conversion cells is 1.9 eV/1.42 eV/1.0 eV.

In the fourth embodiment, by adding a GaInAs cell (0.75 eV) to the GaInP cell 180, the GaAs cell 160 and the GaInPAs cell 120, a four-junction type compound-semiconductor photovoltaic cell 400 is provided. A combination of band gaps of the four photoelectric conversion cells is 1.9 eV/1.42 eV/1.0 eV/0.75 eV.

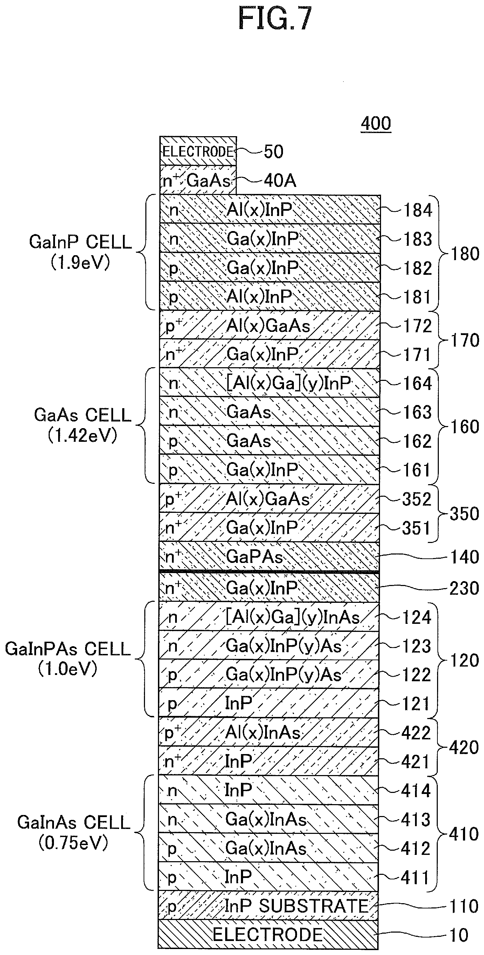

Fig. 7 is a cross-sectional diagram illustrating the compound-semiconductor photovoltaic cell 400 according to the fourth embodiment. In the following, to the same composition element as in the compound-semiconductor photovoltaic cell 300 according to the third embodiment, the same reference numeral is assigned, and an explanation thereof will be omitted.

The compound-semiconductor photovoltaic cell 400 includes an electrode 10, an InP substrate 110, a GaInAs cell 410, a junction layer 420, a GaInPAs cell 120, a junction layer 230, a junction layer 140, a tunnel junction layer 350, a GaAs cell 160, a tunnel junction layer 170, a GaInP cell 180, a contact layer 40A and an electrode 50. Meanwhile, the GaInAs cell 410 is an InP-based photoelectric conversion cell.

The compound-semiconductor photovoltaic cell 400 according to the fourth embodiment is a four-junction type photovoltaic cell in which the GaInAs cell 410 (0.75 eV), the GaInPAs cell 120 (1.0 eV), the GaAs cell 160 (1.42 eV) and the GaInP cell 180 (1.9 eV) are serially connected.

Here, the GaInAs cell 410 and the GaInPAs cell 120 are examples of plural first photoelectric conversion cells manufactured from a first compound-semiconductor material.

In Fig. 7, an incident direction of light is a direction from an upper part to a lower part in the drawing (direction from the GaInP cell 180 to the GaInAs cell 410).

According to the IEEE document (Proceedings of the 28th IEEE Photovoltaic Specialists Conference (2009) pp. 1090-1093), for four-junction photovoltaic cells, a band gap balance of a combination of about 1.9 eV/1.4 eV/1.0 eV/0.7 eV is preferable.

The compound-semiconductor photovoltaic cell 400 is obtained by inserting the GaInAs cell 410 and a tunnel junction layer 420 between the substrate 110 and the GaInPAs cell 120 of the compound-semiconductor photovoltaic cell 100 according to the first embodiment.

The GaInAs cell 410 includes a p-type InP layer 411, a p-type Ga(x)InAs layer 412, an n-type Ga(x)InAs layer 413 and an n-type InP layer 414. The InP layer 411 is a BSF layer and the InP layer 414 is a window layer.

Here, the GaInAs cell 410 may be regarded as a cell, which is configured with the p-type Ga(x)InAs layer 412 and the n-type Ga(x)InAs layer 413, without including the InP layer 411 and the InP layer 414. In this case, it may be treated assuming that the InP layer 414 (window layer) is formed on the light incident side of the GaInAs cell 410 which is configured with the p-type Ga(x)InAs layer 412 and the n-type Ga(x)InAs layer 413, and assuming that the InP layer 411 (BSF layer) is formed on the deep side in the light incident direction.

A band gap between the p-type Ga(x)InAs layer 412 and n-type Ga(x)InAs layer 413 is 0.75 eV.

The tunnel junction layer 420 is formed between the GaInPAs cell 120 and the GaInAs cell 410. The tunnel junction layer 420 includes an n⁺-type InP layer 421 and a p⁺-type Al(x)InAs layer 422.

For impurity for causing the conductivity type of the InP layer 421 to become n⁺-type, for example, silicon (Si) may be used. For impurity for causing the conductivity type of the Al(x)InAs layer 422 to become p⁺-type, for example, carbon (C) may be used. The n⁺-type InP layer 421 and the p⁺-type Al(x)InAs layer 422 form a thin p-n junction which is doped at high concentration.

Both the InP layer 421 of the tunnel junction layer 420 and the Al(x)InAs layer 422 are doped at higher concentration than the GaInPAs cell 120. The tunnel junction layer 420 is a junction layer arranged so that an electric current flows between the p-type Ga(x)InP(y)As layer 122 of the GaInPAs cell 120 and the n-type Ga(x)InAs layer 413 of the GaInAs cell 410 by tunnel junction.

The compound-semiconductor photovoltaic cell 400 according to the fourth embodiment has a combination of band gaps of 1.9 eV/1.42 eV/1.0 eV/0.75 eV according to four photoelectric conversion cells of the GaInP cell 180, the GaAs cell 160, the GaInPAs cell 120 and the GaInAs cell 410.

Therefore, according to the fourth embodiment, a compound-semiconductor photovoltaic cell 400 whose energy conversion efficiency is further higher than the compound-semiconductor photovoltaic cell 300 according to the third embodiment can be provided.

Meanwhile, by removing the junction layer 140 and the n⁺-type GaInP layer 351 and forming a tunnel junction of the junction layer 230 and the p⁺-type AlGaAs layer 352, the compound-semiconductor photovoltaic cell may be made thinner than the compound-semiconductor photovoltaic cell 400 shown in Fig. 7 while suppressing absorption of light.

Further, the present invention is not limited to these embodiments, but various variations and modifications may be made without departing from the scope of the appended claims.

## Claims

1. A compound-semiconductor photovoltaic cell (100, 200, 201, 300, 400) comprising:
a compound-semiconductor substrate (110);
one or more first photoelectric conversion cells (120, 410) formed of a first compound-semiconductor material and laminated on the compound-semiconductor substrate (110);
a first junction layer (130, 230) formed of a second compound-semiconductor material and laminated on the one or more first photoelectric conversion cells;
a second junction layer (140) formed of a third compound-semiconductor material and joined to the first junction layer (130, 230) directly or indirectly; and
one or more second photoelectric conversion cells (160, 180) formed of a fourth compound-semiconductor material, joined to the one or more first photoelectric conversion cells (120, 410) via the first junction layer (130, 230) and the second junction layer (140), and arranged on a light incident side of the one or more first photoelectric conversion cells (120, 410) in a light incident direction, wherein band gaps of the one or more first photoelectric conversion cells (120, 410) and the one or more second photoelectric conversion cells (160, 180) are made smaller from the incident side toward a deep side in the light incident direction, in a case of a single second photoelectric conversion cell (160), a band gap of the second junction layer (140) is greater than a band gap of the second photoelectric conversion cell (160), and in a case of plural second photoelectric conversion cells (160, 180), the band gap of the second junction layer (140) is greater than a band gap of at least one second conversion cell of the plural second photoelectric conversion cells (160, 180), the one or more second photoelectric conversion cells (160, 180) are gallium arsenide (GaAs)-based photovoltaic cells, and
**characterized in that** the second junction layer (140) is a gallium phosphide arsenide (GaPAs) layer.

2. The compound-semiconductor photovoltaic cell (100, 200, 201, 300, 400) as claimed in claim 1, wherein the one or more first photoelectric conversion cells (120, 410) are indium phosphide (InP)-based photoelectric conversion cells.

3. The compound-semiconductor photovoltaic cell (200) as claimed in claim 2, wherein the first junction layer (230) is a gallium phosphide antimonide (GaPSb) layer or a gallium indium phosphide (GaInP) layer which has a tensile strain applied to an InP substrate (110).

4. The compound-semiconductor photovoltaic cell (100, 200, 201, 300, 400) as claimed in any one of claims 1 to 3, wherein the one or more second photoelectric conversion cells (160, 180) are plural photoelectric conversion cells.

5. The compound-semiconductor photovoltaic cell (100, 200) as claimed in any one of claims 1 to 4, wherein a tunnel junction layer or a part of a tunnel junction layer is formed with the first junction layer (230) and the second junction layer (140).

6. The compound-semiconductor photovoltaic cell (300, 400) as claimed in any one of claims 1 to 4, wherein a first photoelectric conversion cell of the one or more first photoelectric conversion cells (120) which is positioned on the most light incident side and a second photoelectric conversion cell of the one or more second photoelectric conversion cells (160) which is positioned on the deepest side in the light incident direction are electrically connected via a tunnel junction, and the tunnel junction is arranged on a light incident side of the second junction layer (140).

7. The compound-semiconductor photovoltaic cell (300, 400) as claimed in claim 6, wherein the tunnel junction is formed of a material whose band gap is greater than a band gap of the second photoelectric conversion cell positioned on the deepest side in the light incident direction.

8. The compound-semiconductor photovoltaic cell (300, 400) as claimed in claim 7, wherein the tunnel junction includes a p⁺-type aluminum gallium arsenide (p⁺AlGaAs) layer and an n⁺-type gallium indium phosphide (n⁺GaInP) layer.

9. The compound-semiconductor photovoltaic cell (201) as claimed in any one of claims 1 to 4 further comprising a conductive nanoparticle array configured to join the first junction layer (230) and the second junction layer (140).

10. A manufacturing method of a compound-semiconductor photovoltaic cell (100) comprising:
forming one or more first photoelectric conversion cells (120) of a first compound-semiconductor material on a first compound-semiconductor substrate (110);
forming a first junction layer (130) of a second compound-semiconductor material on the one or more first photoelectric conversion cells (120);
forming one or more second photoelectric conversion cells (160, 180) of a fourth compound-semiconductor material which are arranged on a light incident side of the one or more first photoelectric conversion cells (120) in a light incident direction on a second compound-semiconductor substrate (20);
forming a second junction layer (140) of a third compound-semiconductor material on the one or more second photoelectric conversion cells (160,180);
joining the first junction layer (130) to the second junction layer (140) directly or indirectly; and
removing the second compound-semiconductor substrate (20), wherein band gaps of the one or more first photoelectric conversion cells (120) and the one or more second photoelectric conversion cells (160, 180) are made smaller from the incident side toward a deep side in the light incident direction, in a case of a single second photoelectric conversion cell (160), a band gap of the second junction layer (140) is greater than a band gap of the second photoelectric conversion cell (160), and in a case of plural second photoelectric conversion cells (160, 180), the band gap of the second junction layer (140) is greater than a band gap of at least one second conversion cell of the plural second photoelectric conversion cells (160, 180), the one or more second photoelectric conversion cells (160, 180) are GaAs-based photovoltaic cells, and
**characterized in that** the second junction layer (140) is a GaPAs layer.

## Patentansprüche

1. Verbindungshalbleiter-Photovoltaikzelle (100, 200, 201, 300, 400), umfassend:
ein Verbindungshalbleitersubstrat (110);
eine oder mehrere erste photoelektrische Umwandlungszellen (120, 410), gebildet aus einem ersten Verbindungshalbleitermaterial und auf das Verbindungshalbleitersubstrat (110) laminiert;
eine erste Verbindungsschicht (130, 230), gebildet aus einem zweiten Verbindungshalbleitermaterial und auf die eine oder mehreren ersten photoelektrischen Umwandlungszellen laminiert;
eine zweite Verbindungsschicht (140), gebildet aus einem dritten Verbindungshalbleitermaterial und auf die erste Verbindungsschicht (130, 230) direkt oder indirekt laminiert; und
eine oder mehrere zweite photoelektrische Umwandlungszellen (160, 180), gebildet aus einem vierten Verbindungshalbleitermaterial, verbunden mit der einen oder den mehreren ersten photoelektrischen Umwandlungszellen (120, 410) über die erste Verbindungsschicht (130, 230) und die zweite Verbindungsschicht (140),
und angeordnet auf einer Lichteinfallsseite der einen oder mehreren ersten photoelektrischen Umwandlungszellen (120, 410) in eine Lichteinfallsrichtung, wobei Bandlücken der einen oder mehreren ersten photoelektrischen Umwandlungszellen (120, 410) und der einen oder mehreren zweiten photoelektrischen Umwandlungszellen (160, 180) von der Einfallsseite zu einer tiefen Seite in die Lichteinfallsrichtung verkleinert werden, im Falle einer einzigen zweiten photoelektrischen Umwandlungszelle (160) ist eine Bandlücke der zweiten Verbindungsschicht (140) größer als eine Bandlücke der zweiten photoelektrischen Umwandlungszelle (160) und im Fall mehrerer zweiter photoelektrischer Umwandlungszellen (160, 180) ist die Bandlücke der zweiten Verbindungsschicht (140) größer als eine Bandlücke der mindestens einen zweiten Umwandlungszelle der mehreren zweiten photoelektrischen Umwandlungszellen (160, 180),
die eine oder mehreren zweiten photoelektrischen Umwandlungszellen (160, 180) sind Galliumarsenid (GaAs) -basierte Photovoltaikzellen und **dadurch gekennzeichnet, dass** die zweite Verbindungsschicht (140) eine Galliumphosphidarsenid (GaPAs) -Schicht ist.

2. Verbindungshalbleiter-Photovoltaikzelle (100, 200, 201, 300, 400) nach Anspruch 1, wobei die eine oder mehreren ersten photoelektrischen Umwandlungszellen (120, 410) Indiumphosphid (InP) -basierte photoelektrische Umwandlungszellen sind.

3. Verbindungshalbleiter-Photovoltaikzelle (200) nach Anspruch 2, wobei die erste Verbindungsschicht (230) eine Galliumphosphidantimonid (GaPSb) -Schicht oder eine Galliumindiumphosphid (GaInP) -Schicht ist, die eine Zugbelastung auf ein InP-Substrat (110) ausgeübt bekommt.

4. Verbindungshalbleiter-Photovoltaikzelle (100, 200, 201, 300, 400) nach einem der Ansprüche 1 bis 3, wobei die eine oder mehreren zweiten photoelektrischen Umwandlungszellen (160, 180) mehrere photoelektrische Umwandlungszellen sind.

5. Verbindungshalbleiter-Photovoltaikzelle (100, 200) nach einem der Ansprüche 1 bis 4, wobei eine Tunnelverbindungsschicht oder ein Teil einer Tunnelverbindungsschicht mit der ersten Verbindungsschicht (230) und der zweiten Verbindungsschicht (140) gebildet ist.

6. Verbindungshalbleiter-Photovoltaikzelle (300, 400) nach einem der Ansprüche 1 bis 4, wobei eine erste photoelektrische Umwandlungszelle der einen oder mehreren ersten photoelektrischen Umwandlungszellen (120), die auf der Seite mit am meisten Lichteinfall positioniert ist, und eine zweite photoelektrische Umwandlungszelle der einen oder mehreren zweiten photoelektrischen Umwandlungszellen (160), die auf der tiefsten Seite in der Lichteinfallsrichtung positioniert ist, über eine Tunnelverbindung elektrisch verbunden sind, und die Tunnelverbindung auf einer Lichteinfallsseite der zweiten Verbindungsschicht (140) angeordnet ist.

7. Verbindungshalbleiter-Photovoltaikzelle (300, 400) nach Anspruch 6, wobei die Tunnelverbindung aus einem Material gebildet ist, dessen Bandlücke größer als eine Bandlücke der zweiten photoelektrischen Umwandlungszelle ist, positioniert auf der tiefsten Seite in der Lichteinfallsrichtung.

8. Verbindungshalbleiter-Photovoltaikzelle (300, 400) nach Anspruch 7, wobei die Tunnelverbindung eine p⁺-Typ-Aluminiumgalliumarsenid (p⁺AlGaAs) -Schicht und eine n⁺-Typ-Galliumindiumphosphid (n⁺GaInP) -Schicht beinhaltet.

9. Verbindungshalbleiter-Photovoltaikzelle (201) nach einem der Ansprüche 1 bis 4, ferner umfassend eine leitfähige Nanopartikelanordnung, die konfiguriert ist, um die erste Verbindungsschicht (230) und die zweite Verbindungsschicht (140) zu verbinden.

10. Herstellungsverfahren einer Verbindungshalbleiter-Photovoltaikzelle (100), umfassend:
Bilden von einer oder mehreren ersten photoelektrischen Umwandlungszellen (120) aus einem ersten Verbindungshalbleitermaterial auf einem ersten Verbindungshalbleitersubstrat (110);
Bilden einer ersten Verbindungsschicht (130) aus einem zweiten Verbindungshalbleitermaterial und auf der einen oder den mehreren ersten photoelektrischen Umwandlungszellen (120);
Bilden von einer oder mehreren zweiten photoelektrischen Umwandlungszellen (160, 180) aus einem vierten Verbindungshalbleitermaterial, die auf einer Lichteinfallsseite der einen oder mehreren ersten photoelektrischen Umwandlungszellen (120) in einer Lichteinfallsrichtung auf einem zweiten Verbindungshalbleitersubstrat (20) angeordnet sind;
Bilden einer zweiten Verbindungsschicht (140) aus einem dritten Verbindungshalbleitermaterial auf der einen oder den mehreren zweiten photoelektrischen Umwandlungszellen (160, 180);
Verbinden der ersten Verbindungsschicht (130) mit der zweiten Verbindungsschicht (140) direkt oder indirekt; und
Entfernen des zweiten Verbindungshalbleitersubstrats (20), wobei Bandlücken der einen oder mehreren ersten photoelektrischen Umwandlungszellen (120) und der einen oder mehreren zweiten photoelektrischen Umwandlungszellen (160, 180) von der Einfallsseite zu einer tiefen Seite in die Lichteinfallsrichtung verkleinert werden, im Falle einer einzigen zweiten photoelektrischen Umwandlungszelle (160) ist eine Bandlücke der zweiten Verbindungsschicht (140) größer als eine Bandlücke der zweiten photoelektrischen Umwandlungszelle (160) und im Fall mehrerer zweiter photoelektrischer Umwandlungszellen (160, 180) ist die Bandlücke der zweiten Verbindungsschicht (140) größer als eine Bandlücke der mindestens einen zweiten Umwandlungszelle der mehreren zweiten photoelektrischen Umwandlungszellen (160, 180),
die eine oder mehreren zweiten photoelektrischen Umwandlungszellen (160, 180) sind GaAs-basierte Photovoltaikzellen und **dadurch gekennzeichnet, dass** die zweite Verbindungsschicht (140) eine GaPAs-Schicht ist.

## Revendications

1. Cellule photovoltaïque à semi-conducteurcomposé (100, 200, 201, 300, 400) comprenant:
un substrat semi-conducteur composé (110);
une ou plusieurs premières cellules de conversion photoélectrique (120, 410) formées d'un premier matériau semi-conducteur composé et stratifiées sur le substrat semi-conducteur composé (110);
une première couche de jonction (130, 230) formée d'un second matériau semi-conducteur composé et stratifiée sur l'un ou plusieurs premières cellules de conversion photoélectrique;
uneseconde couche de jonction (140) formée d'un troisième matériau semi-conducteur composé et jointe à la première couche de jonction (130, 230) directement ou indirectement; et
une ou plusieurs secondes cellules de conversion photoélectrique (160, 180) formées d'un quatrième matériau semi-conducteur composé, jointes à une ou plusieurs premières cellules de conversion photoélectrique (120, 410) via la première couche de jonction (130, 230) et la seconde couche de jonction (140), et disposées sur un côté incident de lumière de l'une ou plusieurs premières cellules de conversion photoélectrique (120, 410) dans une direction incidente de lumière, dans laquelle les bandes interdites de l'une ou plusieurs premières cellules de conversion photoélectrique (120, 410) et de l'une ou plusieurs secondes cellules de conversion photoélectrique (160, 180) sont rendues plus petites à partir du côté incident vers un côté profond dans la direction incidente de lumière, dans le cas d'une seule seconde cellule de conversion photoélectrique (160), une bande interdite de la seconde couche de jonction (140) est supérieure à une bande interdite de la seconde cellule de conversion photoélectrique (160), et dans le cas de plusieurs secondes cellules de conversion photoélectrique (160, 180), la bande interdite de la seconde couche de jonction (140) est supérieure à une bande interdite d'au moins une seconde cellule de conversion des plusieurs secondes cellules de conversion photoélectrique (160, 180), l'une ou plusieurs secondes cellules de conversion photoélectrique (160, 180) sont des cellules photovoltaïques à base d'arséniure de gallium (GaAs), et **caractérisée en ce que** la seconde couche de jonction (140) est une couche d'arséniure de phosphure de gallium (GaPAs).

2. Cellule photovoltaïque à semi-conducteurcomposé (100, 200, 201, 300, 400) selon la revendication 1, dans laquelle l'une ou plusieurs premières cellules de conversion photoélectrique (120, 410) sont des cellules de conversion photoélectrique à base de phosphure d'indium (InP).

3. Cellule photovoltaïque à semi-conducteurcomposé (200) selon la revendication 2, dans laquelle la première couche de jonction (230) est une couche d'antimoniure de phosphure de gallium (GaPSb) ou une couche de phosphure d'indium de gallium (GaInP) qui a une contrainte de traction appliquée à un substrat deInP (110).

4. Cellule photovoltaïque à semi-conducteurcomposé (100, 200, 201, 300, 400) selon l'une quelconque des revendications 1 à 3, dans laquelle l'une ou plusieurs secondes cellules de conversion photoélectrique (160, 180) sont plusieurs cellules de conversion photoélectrique.

5. Cellule photovoltaïque à semi-conducteurcomposé (100, 200) selon l'une quelconque des revendications 1 à 4, dans laquelle une couche de jonction tunnel ou une partie d'une couche de jonction tunnel est formée avec la première couche de jonction (230) et la seconde couche de jonction (140).

6. Cellule photovoltaïque à semi-conducteurcomposé (300, 400) selon l'une quelconque des revendications 1 à 4, dans laquelle une première cellule de conversion photoélectrique de l'une ou plusieurs premières cellules de conversion photoélectrique (120) qui est positionnée sur le côté le plus incident de lumièreet une seconde cellule de conversion photoélectrique de l'une ou plusieurs secondes cellules de conversion photoélectrique (160) qui est positionnée sur le côté le plus profond dans la direction incidente de lumière sont connectées électriquement via une jonction tunnel, et la jonction tunnel est agencée sur un côté incident de lumière de la seconde couche de jonction (140).

7. Cellule photovoltaïque à semi-conducteurcomposé (300,400) selon la revendication 6, dans laquelle la jonction tunnel est formée d'un matériau dont la bande interdite est supérieure à une bande interdite de la seconde cellule de conversion photoélectrique positionnée du côté le plus profond dans la direction incidente de lumière.

8. Cellule photovoltaïque à semi-conducteurcomposé (300, 400) selon la revendication 7, dans laquelle la jonction tunnel comprend une couche d'arséniure d'aluminium de gallium de type p⁺ (p⁺AlGaAs) et une couche de phosphure d'indium de gallium de type n⁺ (n⁺GaInP).

9. Cellule photovoltaïque à semi-conducteur composé (201), selon l'une quelconque des revendications 1 à 4, comprenant en outre un réseau de nanoparticules conductrices configuré pour joindre la première couche de jonction (230) et la seconde couche de jonction (140).

10. Procédé de fabrication d'une cellule photovoltaïque à semi-conducteurcomposé (100) comprenant:
la formation d'une ou plusieurs premières cellules de conversion photoélectrique (120) d'un premier matériau semi-conducteur composé sur un premier substrat semi-conducteur composé (110);
la formation d'une première couche de jonction (130) d'un second matériau semi-conducteur composé sur l'une ou plusieurs premières cellules de conversion photoélectrique (120);
la formation d'une ou plusieurs secondes cellules de conversion photoélectrique (160, 180) d'un quatrième matériau semi-conducteur composé qui sont disposées sur un côté incident de lumière de l'une ou plusieurs premières cellules de conversion photoélectrique (120) dans une direction incidente de lumière sur un second substrat semi-conducteur composé (20);
la formation d'une seconde couche de jonction (140) d'un troisième matériau semi-conducteur composé sur l'une ou plusieurssecondes cellules de conversion photoélectrique(160, 180);
la jonction de la première couche de jonction (130) à la seconde couche de jonction (140) directement ou indirectement; et
le retrait du second substrat semi-conducteur composé (20), dans lequel les bandes interdites de l'une ou plusieurs premières cellules de conversion photoélectrique (120) et de l'une ou plusieurs secondes cellules de conversion photoélectrique (160, 180) sont réduites à partir du côté incident vers une côté profonddans la direction incidente de lumière, dans le cas d'une seule seconde cellule de conversion photoélectrique (160), une bande interdite de la seconde couche de jonction (140) est supérieure à une bande interdite de la seconde cellule de conversion photoélectrique (160), et dans un cas de plusieurs secondes cellules de conversion photoélectrique (160, 180), la bande interdite de la seconde couche de jonction (140) est supérieure à une bande interdite d'au moins une seconde cellule de conversion des plusieurs secondes cellules de conversion photoélectrique (160, 180), l'une ou plusieurs secondes cellules de conversion photoélectrique (160, 180) sont des cellules photovoltaïques à base de GaAs, et **caractérisé en ce que** la seconde couche de jonction (140) est une couche de GaPAs.
